# EUROPEAN PATENT APPLICATION

(11) **EP 1 300 962 A1**
(43) Date of publication of application: **09.04.2003**
(21) Application number: 02708690.9
(22) Date of filing: 27.03.2002
(51) Int. Cl.: H04B 1/707

(54) **AUTOMATIC FREQUENCY CONTROL DEVICE AND AUTOMATIC FREQUENCY CONTROL METHOD**

(30) Priority: 30.05.2001 JP 2001163318
(71) Applicant: MITSUBISHI DENKI KABUSHIKI KAISHA, Tokyo 100-8310 (JP)
(72) Inventor: SAKAISHI, Takuya, Mitsubishi Denki KK, Chiyoda-ku, Tokyo 100--8310 (JP)
(74) Representative: Pfenning, Meinig & Partner GbR
(86) International application number: JP0203007
(87) International publication number: WO02099988

(57) **Abstract**

An automatic frequency control device has an AFC mode controller (21) that changes over an operation mode according to a frequency deviation calculated in advance, phase rotation quantity detecting sections (22-1 to 22-n) and a maximum rate combiner (23) that detect a phase rotation quantity per unit time of outputs of a plurality of correlators according to a specified operation mode, a reliability calculating section (24) and an effective slot deciding section (25) that decide effectiveness or non-effectiveness of data in a receiving slot by using the outputs of the correlators, an n-slot averaging section (26) that averages a phase rotation quantity per unit time corresponding to an effective receiving slot, during an n slot time, a Δf calculating section (27) that calculates a frequency deviation based on a phase rotation quantity after averaging, and a VCO control voltage calculator (12) that carries out a VCO control when the reliability of the calculated frequency deviation exceeds a certain level.

## Description

### TECHNICAL FIELD

The present invention relates to an automatic frequency control device that uses a W-CDMA communication technique for an automobile telephone, a portable telephone and the like. The present invention relates, more particularly, to an automatic frequency control device and an automatic frequency control method for carrying out an automatic frequency control based on a reception signal.

### BACKGROUND ART

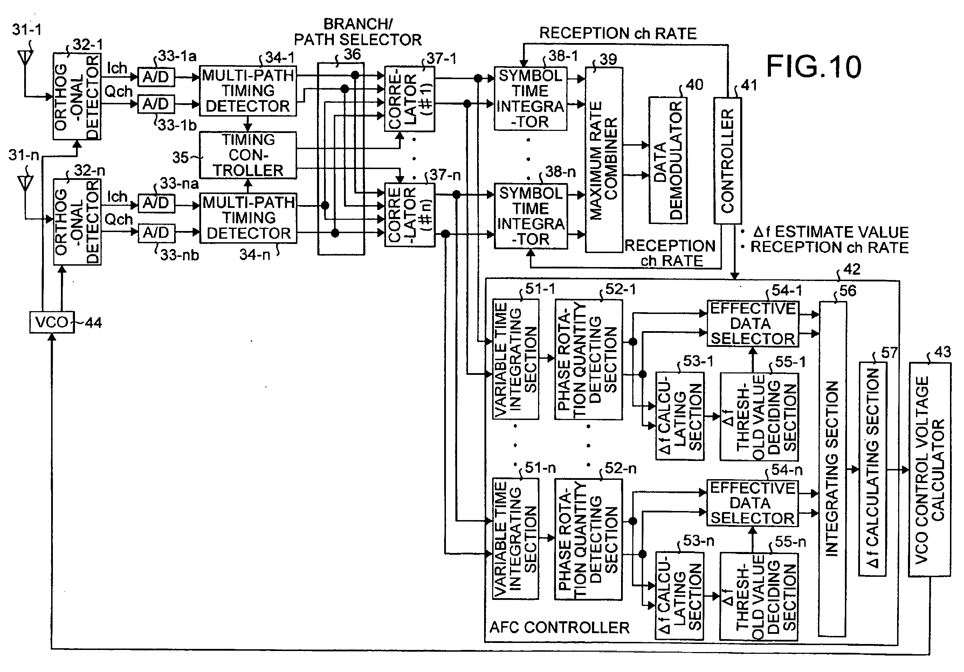

A conventional automatic frequency control device will be explained below. Fig. 10 shows a structure of a conventional digital radio receiving apparatus (i.e., a conventional automatic frequency control device) described in Japanese Patent Application Laid-open No. 2000-78216. In Fig. 10, reference numerals 31-1 to 31-n denote antennas (hereinafter collectively referred to as "antenna (31)"), 32-1 to 32-n denote orthogonal detectors (hereinafter collectively referred to as "detector (32)"), 33-1a to 33-na and 33-1b to 33-nb denote A/D converters (hereinafter collectively referred to as "AID converter (33)"), and 34-1 to 34-n denote multi-path timing detectors (hereinafter collectively referred to as "multi-path timing detector (34)"). Moreover, reference numeral 35 denotes a timing controller, 36 denotes a branch/path selector, and 37-1 to 37-n denote correlators (hereinafter collectively referred to as "correlators (37)"). Moreover, reference numeral 38-1 to 38-n denote symbol time integrators (hereinafter collectively referred to as "symbol time integrator (38)"), 39 denotes a maximum rate combiner, 40 denotes a data demodulator, 41 denotes a controller, 42 denotes an AFC controller, 43 denotes a VCO control voltage calculator, and 44 denotes a voltage controlled oscillator (VCO). Moreover, reference numerals 51-1 to 51-n denote variable time integrating sections (hereinafter collectively referred to as "variable time integrating section (51)"), 52-1 to 52-n denote phase rotation quantity detecting sections (hereinafter collectively referred to as "phase rotation quantity detecting section (52)"), 53-1 to 53-n denote Δf calculating sections (hereinafter collectively referred to as "Δf calculating section (53)"), 54-1 to 54-n denote effective data selectors (hereinafter collectively referred to as "effective data selector (54)"), 55-1 to 55-n denote Δf threshold value deciding sections (hereinafter collectively referred to as "Δf threshold value deciding section (55)"), 56 denotes an integrating section, and 57 denotes a Δf calculating section.

The operation of the conventional digital radio receiving apparatus will be explained below. The orthogonal detector 32 detects a reception signal received by the antenna (31) and converts the frequency of the reception signal to obtain a baseband signal. The A/D converter (33) corresponding to Ich (i.e., I channel) and Qch (i.e., Q channel) convert the signals output from the orthogonal detector (32) into digital signals.

The multi-path timing detector (34) detects a timing of each path of the reception signal. The timing controller 35 controls an inverse spreading timing of the correlator (37) allocated corresponding to each reception path timings. The branch/path selector 36 distributes the reception signal to the correlator (37), and by matching each reception path timings each correlator (37) obtains a correlation between respective Ich and Qch and a spreading code used at a transmission time. The symbol time integrator (38) receives the correlation value and carries out an integration processing for a symbol time. The maximum rate combiner 39 carries out a maxim rate combining to each reception path signal after the integration processing to obtain a combined signal, and the data demodulator 40 demodulates the combined signal.

The variable time integrating section (51) receives a correlation value of a pilot symbol portion from the correlator (37) and, for example, carries out an integration processing for a symbol time of 1/2, 1, 2 or 4 symbols to obtain integration value. The phase rotation quantity detecting section (52) receives the integration value, carries out a complex multiplication of integration values mutually adjacent in time, and obtains a phase rotation quantity of a pilot symbol per 1/2, 1 or 2 symbols or per one slot time.

The Δf calculating section (53) receives the phase rotation quantity of a pilot symbol per 1/2, 1 or 2 symbols or per one slot time and converts this phase rotation quantity into a frequency deviation Δf. The Δf threshold value deciding section (55) decides the frequency deviation Δf having a variation equal to or above absolute precision of VCO as non-effective data having low reliability.

The effective data selector (54) receives the phase rotation quantity from the phase rotation quantity detecting section (52), rounds off the data that has been decided as non-effective by the Δf threshold value deciding section (55) based on the phase rotation quantity, and outputs only the remaining effective data. The integrating section 56 integrates the received effective data for the time of a few frames. The Δf calculating section 57 receives the result of integration, converts the result of integration into the frequency deviation Δf, and obtains a final frequency deviation Δf. The VCO control voltage calculator 43 receives the frequency deviation Δf, converts the frequency deviation Δf into a VCO control voltage, and controls a control voltage of the VCO 44, thereby to realize the automatic frequency control (AFC) operation.

However, the conventional automatic frequency control device takes into consideration a channel format having a pilot symbol partially embedded in a reception channel of a variable rate, detects a frequency deviation Δf by utilizing a part of pilot symbols in the channel during a demodulation. Therefore, there has been a problem that it is not possible to obtain a high-precision frequency deviation Δf.

On the other hand, in a down (i.e. from a base station to a mobile station) circuit of a W-CDMA communication system prescribed by 3GPP TS25.211 V3.5, 0, a CPICH (Common Pilot Channel) has a fixed transmission rate, and relatively high transmission power is expected. The CPICH is a channel in which a symbol (a pilot symbol) of known data is continuously transmitted from a transmitter to a receiver. When this CPICH is used, for example, it is possible to detect a higher-precision frequency deviation Δf. Therefore, in the following, explanation will be made by using an example that the CPICH is used for detecting the Δf. However, when the channel is a one (for example, an SCH (Synchronization Channel)) in which a known data symbol is transmitted like the CPICH, it is also possible to detect the Δf in a similar manner by using any channel. A Channelization_Code that is used for spreading in the CPICH has a code length of 256 chips, and has the same phase for all the chips. On the other hand, a Channelization_Code that is used for spreading in a PCCPCH (Primary Common Control Physical Channel) also has a code length of 256 bits but the phase is inverted by 180° in the former-half 128 chips as compared to the latter-half 128 chips. It is know that the orthogonality between multichannels is lost when the frequency deviation Δf is large. Particularly, like in the CPICH and the PCCPCH, if codes having relatively similar characteristics are used for spreading between channels, it becomes difficult to distinguish interference components between a target channel and other channel. Consequently, if only the CPICH is used for detecting Δf then there has been a problem that there is a possibility of an erroneous detection of the Δf.

It is an object of the present invention to provide an automatic frequency control device and an automatic frequency control method that can realize a high-precision lead-in of AFC even if, like in the CPICH and the PCCPCH, codes having relatively similar characteristics are used for spreading between channels.

### DISCLOSURE OF THE INVENTION

An automatic frequency control device according to the present invention comprises, an operation mode control unit (corresponding to an AFC mode controller 21 in an embodiment to be described later) that changes over a unit time (an operation mode) to calculate a phase rotation quantity according to a frequency deviation calculated in advance, a phase rotation quantity detecting unit (corresponding to phase rotation quantity detecting sections 22-1 to 22-n, and a maximum rate combiner 23) that detects a phase rotation quantity per unit time, by using symbol correlation values of channels in which known data is transmitted between a transmitter and a receiver, obtained as outputs of a plurality of correlators according to a specified operation mode, a data deciding unit (corresponding to a reliability calculating section 24, and an effective slot deciding section 25) that decides effectiveness or non-effectiveness of reception data in a receiving slot by using the symbol correlation values, a slot averaging unit (corresponding to an n-slot averaging section 26) that averages a phase rotation quantity per unit time corresponding to a receiving slot that has been decided as effective, during a predetermined slot time, a frequency deviatlon/reliability calculating unit (corresponding to a Δf calculating section 27) that calculates a frequency deviation based on a phase rotation quantity after averaging, and obtains reliability of the frequency deviation based on the effective number, and a VCO control unit (corresponding to a VCO control voltage calculator 12) that decides reliability of the calculated frequency deviation, and carries out a VCO control when the reliability exceeds a certain level.

In an automatic frequency control device relating to the next invention, the operation mode control unit can select a first operation mode for detecting a frequency deviation based on a phase rotation quantity per one symbol time, and a second operation mode for detecting a frequency deviation based on a phase rotation quantity per one slot time, as the operation mode.

In an automatic frequency control device relating to the next invention, the operation mode control unit shifts to the second operation mode in which it is possible to detect a frequency deviation in higher precision, when an absolute value of the detected frequency deviation has been continuously equal to or lower than a threshold value over a first predetermined number of times prescribed in advance during a continuous operation in the first operation mode, and shifts to the first operation mode in which a detectable range of a frequency deviation is wide, when an absolute value of the detected frequency deviation has continuously exceeded a threshold value over a second predetermined number of times prescribed in advance during a continuous operation in the second operation mode.

In an automatic frequency control device relating to the next invention, the operation mode control unit shifts to the second operation mode in which it is possible to detect a frequency deviation in higher precision, when an absolute value of the detected frequency deviation has been continuously equal to or lower than a threshold value over a first predetermined number of times prescribed in advance during a continuous operation in the first operation mode, shifts to the first operation mode in which a detectable range of a frequency deviation is wide, when an absolute value of the detected frequency deviation has continuously exceeded a threshold value over a second predetermined number of times prescribed in advance during a continuous operation in the second operation mode, and periodically shifts to a third operation mode at a rate of once per a specified number of times of detecting a frequency deviation during a continuous operation in the second operation mode, returns to the second operation mode when an absolute value of the detected frequency deviation is equal to or lower than a threshold value, and shifts to the first operation mode when an absolute value of the detected frequency deviation has continuously exceeded a threshold value over a third predetermined number of times.

An automatic frequency control device relating to the next invention further comprises a reception right/wrong deciding unit (corresponding to a reception right/wrong deciding section 14) that decides right or wrong of reception data after a demodulation, and decides that an AFC lead-in has been a failure and instructs the VCO control unit to carry out VCO control without depending on the detected frequency deviation, when the result of the decision is that a predetermined standard is not satisfied, and thereafter instructs the operation mode control unit to carry out the AFC lead-in again in the first operation mode.

An automatic frequency control method relating to the next invention includes, an operation mode control step of changing over a unit time (an operation mode) to calculate a phase rotation quantity according to a frequency deviation calculated in advance, a phase rotation quantity detecting step of detecting a phase rotation quantity per unit time, by using symbol correlation values of channels in which known data is transmitted between a transmitter and a receiver, obtained as outputs of a plurality of correlators according to a specified operation mode, a data deciding step of deciding effectiveness or non-effectiveness of reception data in a receiving slot by using the symbol correlation values, a slot averaging step of averaging a phase rotation quantity per unit time corresponding to a receiving slot that has been decided as effective, during a predetermined slot time, a frequency deviation/reliability calculating step of calculating a frequency deviation based on a phase rotation quantity after averaging, and obtaining reliability of the frequency deviation based on the effective number, and a VCO control step of deciding reliability of the calculated frequency deviation, and carrying out a VCO control when the reliability exceeds a certain level.

In an automatic frequency control method relating to the next invention, at the operation mode control step, it is made possible to select a first operation mode for detecting a frequency deviation based on a phase rotation quantity per one symbol time, and a second operation mode for detecting a frequency deviation based on a phase rotation quantity per one slot time, as the operation mode.

In an automatic frequency control method relating to the next invention, at the operation mode control step, the operation mode is shifted to the second operation mode in which it is possible to detect a frequency deviation in higher precision, when an absolute value of the detected frequency deviation has been continuously equal to or lower than a threshold value over a first predetermined number of times prescribed in advance during a continuous operation in the first operation mode, and the operation mode is shifted to the first operation mode in which a detectable range of a frequency deviation is wide, when an absolute value of the detected frequency deviation has continuously exceeded a threshold value over a second predetermined number of times prescribed in advance during a continuous operation in the second operation mode.

In an automatic frequency control method relating to the next invention, at the operation mode control step, the operation mode is shifted to the second operation mode in which it is possible to detect a frequency deviation in higher precision, when an absolute value of the detected frequency deviation has been continuously equal to or lower than a threshold value over a first predetermined number of times prescribed in advance during a continuous operation in the first operation mode, the operation mode is shifted to the first operation mode in which a detectable range of a frequency deviation is wide, when an absolute value of the detected frequency deviation has continuously exceeded a threshold value over a second predetermined number of times prescribed in advance during a continuous operation in the second operation mode, and the operation mode is periodically shifted to a third operation mode at a rate of once per a specified number of times of detecting a frequency deviation during a continuous operation in the second operation mode, the operation mode is returned to the second operation mode when an absolute value of the detected frequency deviation is equal to or lower than a threshold value, and the operation mode is shifted to the first operation mode when an absolute value of the detected frequency deviation has continuously exceeded a threshold value over a third predetermined number of times.

An automatic frequency control method relating to the next invention further comprises a reception right/wrong deciding step of deciding right or wrong of reception data after a demodulation, and deciding that an AFC lead-in has been a failure and instructing a VCO control without depending on the detected frequency deviation, when the result of the decision is that a predetermined standard is not satisfied, and thereafter instructing to carry out the AFC lead-in again in the first operation mode.

### BRIEF DESCRIPTION OF THE DRAWINGS

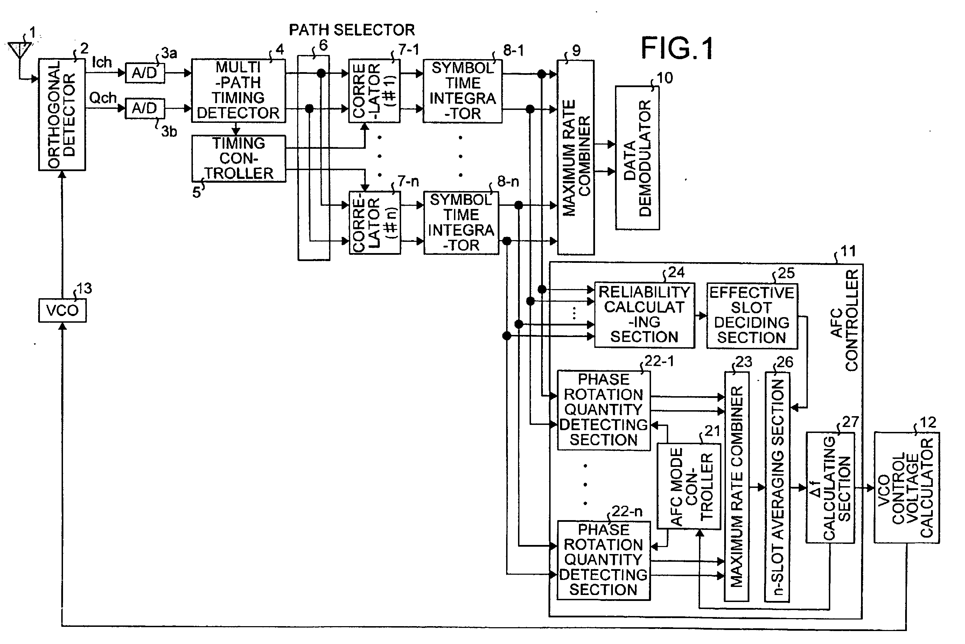

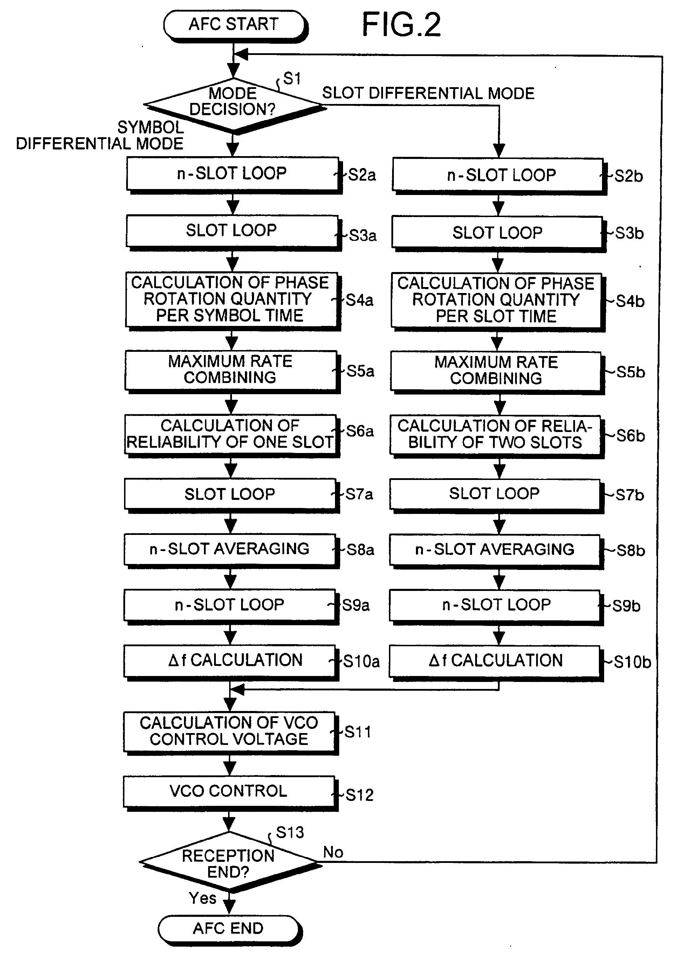

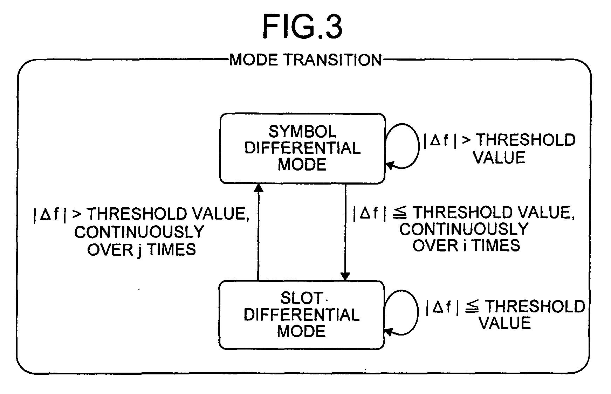

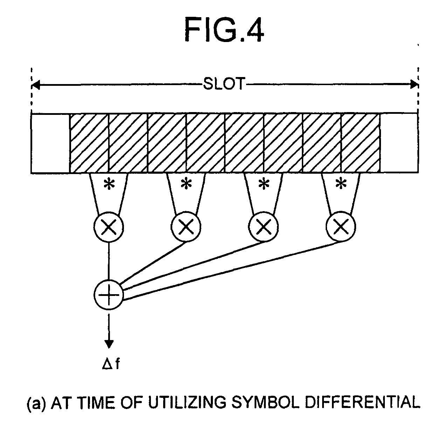

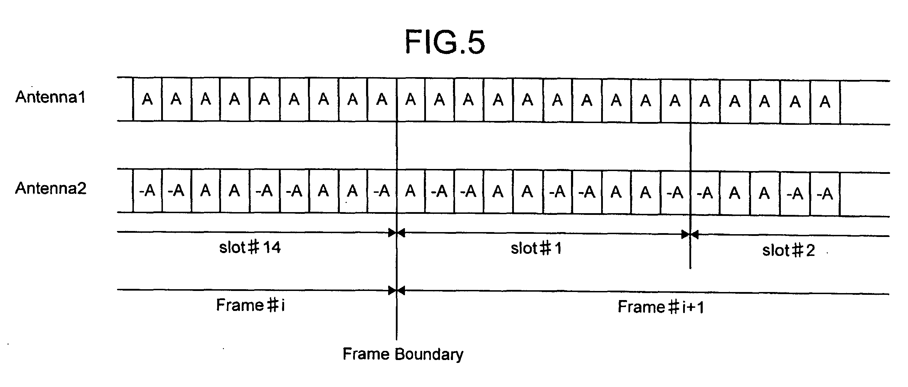

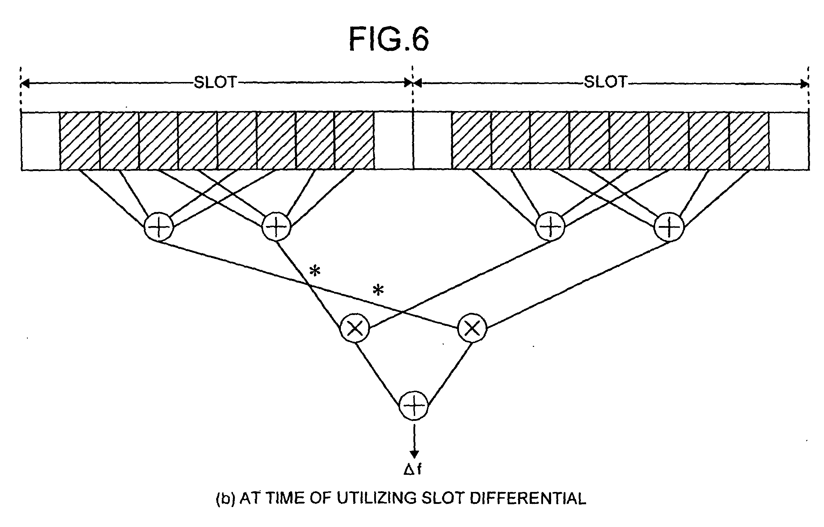

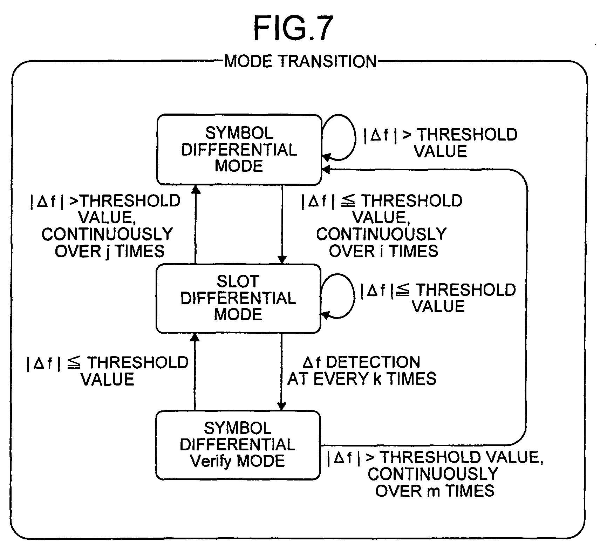

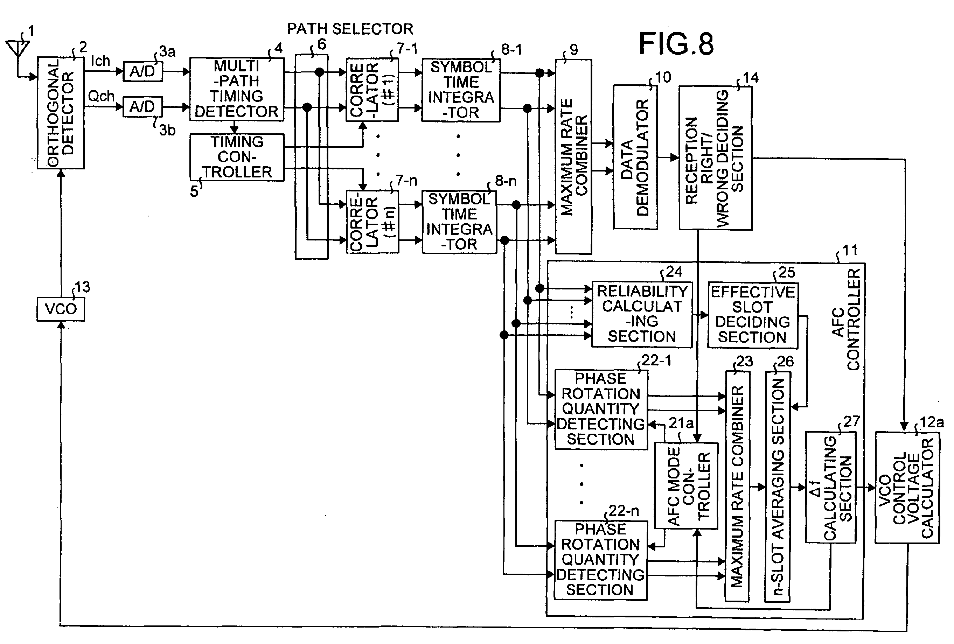

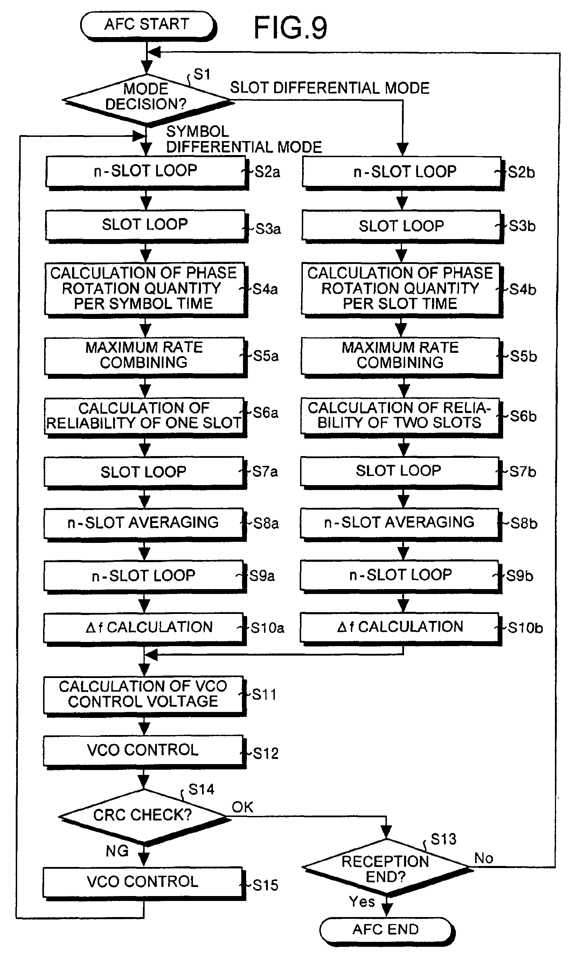

Fig. 1 shows a structure of an automatic frequency control device according to the first and the second embodiments of the present invention; Fig. 2 is a flowchart that shows an AFC control operation according to the first and second embodiments; Fig. 3 explains about a transition of an AFC operation mode in the first embodiment; Fig. 4 shows a method of calculating a phase rotation quantity per one symbol time; Fig. 5 shows a modulation pattern of a CPICH during the operation of a W-CDMA communication system in an STTD mode; Fig. 6 shows a method of calculating a phase rotation quantity per one slot time; Fig. 7 explains about a transition of an AFC operation mode in the second embodiment; Fig. 8 shows a structure of an automatic frequency control device according to the third embodiment of the present invention; Fig. 9 is a flowchart that shows an AFC control operation according to the third embodiment; and Fig. 10 shows a structure of a conventional digital radio receiving apparatus.

### BEST MODE FOR CARRYING OUT THE INVENTION

Exemplary embodiments of the automatic frequency control device and the automatic frequency control method according to the present invention will be explained in detail below with reference to the accompanying drawings. This invention is not limited by these embodiments.

### First Embodiment

Fig. 1 shows a structure of an automatic frequency control device according to the first embodiment of the present invention. In Fig. 1, reference numeral 1 denotes an antenna, 2 denotes an orthogonal detector, 3a and 3b denote A/D converters, 4 denotes a multi-path timing detector, 5 denotes a timing controller, and 6 denotes a path selector. Moreover, reference numerals 7-1 to 7-n denote correlators (hereinafter collectively referred to as "correlator (7)"), 8-1 to 8-n denote symbol time integrators (hereinafter collectively referred to as "symbol time integrator (8)"), 9 denotes a maximum rate combiner, and 10 denotes a data demodulator. Moreover, reference numeral 11 denotes an AFC controller, 12 denotes a VCO control voltage calculator, and 13 denotes the VCO.

Further, in the AFC controller 11, reference numeral 21 denotes an AFC mode controller, 22-1 to 22-n denote phase rotation quantity detecting sections, and 23 denotes a maximum rate combiner. Moreover, reference numeral 24 denotes a reliability calculating section, 25 denotes an effective slot deciding section, 26 denotes an n-slot averaging section, and 27 denotes a Δf calculating section.

The operation of the automatic frequency control device according to the first embodiment will be explained below. The antenna 1 catches a radio signal transmitted from a transmitting station. The orthogonal detector 2 performs a quasi-synchronous detection with respect to the reception signal by using a reception local frequency from the VCO 13, and converts the frequency of the reception signal to obtain a baseband signal. The A/D converter 3 converts the signal, which is an analog signal, output from the orthogonal detector 2 into a digital signal for both the Ich and Qch.

The multi-path timing detector 4 detects a multi-path timing based on the digital reception signal. The timing controller 5 transmits a timing signal to the correlator 7 according to the result of the detection by the multi-path timing detector 4. The path selector 6 distributes a reception signal to the correlators 7-1 to 7-n allocated by reception paths and reception channels.

Each of the correlators 7-1 to 7-n obtains a correlation between a spreading code used at the transmission time and the distributed reception signal. Each of the symbol time integrators 8-1 to 8-n integrates a correlation output of a symbol time according to a transmission rate of the reception signal. The maximum rate combiner 9 carries out a maximum rate combining of a total symbol time integration value. The data demodulator 10 demodulates the reception signal by using the combined result.

On the other hand, the AFC controller 11 obtains a frequency deviation Δf from the total symbol time integration value of the outputs of the symbol time integrators 8-1 to 8-n sharing for data demodulation and for automatic frequency control. The VCO control voltage calculator 12 calculates a control voltage of the VCO 13 based on the frequency deviation Δf. The VCO 13 changes the reception local frequency to be supplied to the orthogonal detector 2 according to the control voltage.

Next, the internal operation of the AFC controller 11 will be explained. The AFC mode controller 21 selects any one mode of a symbol differential mode and a slot differential mode according to the frequency deviation Δf calculated by the Δf calculating section 27 to be described later, and assigns the operation mode to the phase rotation quantity detecting section 22. Each of the phase rotation quantity detecting sections 22-1 to 22-n detects a phase rotation quantity of a symbol per unit time based on each symbol time integration value, according to the specified operation mode. The maximum rate combiner 23 combines all detected phase rotation quantities of a symbol per unit time.

The reliability calculating section 24 calculates a squared slot integration value of the receiving slot based on the symbol time integration value. The effective slot deciding section 25 decides effectiveness or non-effectiveness of the reception data of the receiving slot based on the squared slot integration value. The n-slot averaging section 26 selects the result of the combining of the phase rotation quantities for each one receiving slot based on the result of the decision of the effective slot deciding section 25, and averages only effective data over the n-slot time. Further, the n-slot averaging section 26 counts the number of effective data used for the averaging from among the phase rotation quantities obtained for each one receiving slot, and sets the result of the counting as reliability.

The Δf calculating section 27 calculates a frequency deviation Δf based on the n-slot averaging result and the transmission rate of the reception channel, and outputs the frequency deviation Δf to the VCO control voltage calculator 12. The VCO control voltage calculator 12 calculates a control voltage of the VCO 13 based on this frequency deviation Δf, but here, it decides a threshold value of reliability. When the reliability is not at or above a certain level, the VCO 13 is not controlled.

Fig. 2 is a flowchart that shows the AFC control operation according to the first embodiment. First, the AFC mode controller 21 determines any one AFC operation mode from the symbol differential mode in which Δf is detected based on the phase rotation quantity per one symbol time and the slot differential mode in which Δf is detected based on the phase rotation quantity per one slot time, according to the current frequency deviation Δf (step S1).

Fig. 3 explains about a transition of an AFC operation mode according to a decision of a threshold value. Specifically, when the AFC operation is started that has a possibility that an absolute value of a frequency deviation Δf is larger than a predetermined threshold value prescribed in advance, a symbol differential mode having a relatively wide Δf detectable range is selected. Thereafter, the symbol differential mode is executed continuously, and when an absolute value of a Δf detection value up to the last time has continuously been at or lower than a threshold value over i times, for example, the mode is shifted to a slot differential mode in which a frequency deviation Δf can be detected in higher precision. Here, the slot differential mode is executed continuously, and when an absolute value of a Δf detection value up to the last time has continuously exceeded a threshold value over j times, for example, the mode is shifted to a symbol differential mode again. As the threshold value for deciding a mode, a value within a Δf detectable range is set in which a normal frequency deviation Δf can be detected even in the slot differential mode.

When a symbol differential mode has been selected in the processing at step S1, the AFC controller 11 carries out a loop processing over an n slot period (step S3a to step S8a) and a loop processing over one slot period (step S4a to step S6a).

Each phase rotation quantity detecting section calculates a phase rotation quantity per one symbol time (step S4a). Fig. 4 explains a method of calculating a phase rotation quantity per one symbol time. A complex conjugate is obtained for one correlation value of a symbol adjacent in time, and this complex conjugate is complex multiplied to the other correlation value. Then, when a symbol in the slot is composed of first to tenth symbols, for example, results of a complex multiplication of the second symbol and the third symbol, the fourth symbol and the fifth symbol, the sixth symbol and the seventh symbol, and the eighth symbol and the ninth symbol, respectively, are added together. This processing is carried out in a correlator unit. When a phase rotation quantity per one symbol time according to a frequency deviation Δf is in a range not exceeding ±180°, it is possible to obtain a normal phase rotation quantity.

Fig. 5 shows a modulation pattern of a CPICH (Common Pilot Channel) during the operation of a W-CDMA communication system in an STTD (Space time block coding based transmit antenna diversity) mode. In the present embodiment, during the operation in the STTD mode, even when the phase of the modulation pattern of the CPICH transmitted from one transmission antenna is inverted by 180° at every two symbols, it is possible to obtain a phase rotation quantity per one symbol time, in a similar manner to that in the non-STTD mode operation.

The maximum rate combiner 23 carries out a maximum rate combining to the phase rotation quantity per one symbol time obtained in each correlator in the processing at step S4a (step S5a). This is set as a phase rotation quantity per one symbol time in the slot.

The reliability calculating section 24 calculates effectiveness of the phase rotation quantity detected in the reception slot. Here, a square of a correlation value of each reception symbol in the slot is calculated, and thereafter, all results of the calculation are added, and a squared slot integration value is obtained (step S6a).

The n-slot averaging section 26 averages the phase rotation quantity per one symbol time obtained for each slot over n slot time, in order to obtain a stable phase rotation quantity from a phase rotation quantity that instantaneously varies due to a fading variation or the like (step S8a). The effective slot deciding section 25 carries out a threshold-value decision of the squared slot integration value of a reception signal calculated at step S6a, and in the n-slot averaging, the averaging is carried out using only phase rotation quantities of slots that exceed the threshold value. In other words, by making the reception data of the slots having low correlation values non-effective, a phase rotation quantity having higher precision is obtained. In this case, the number of phase rotation quantities that are used for the averaging is counted as the reliability of the result of averaging n slots.

After completing the above loop processing, the Δf calculating section 27 calculates a frequency deviation Δf based on the obtained phase rotation quantity per one symbol time and a transmission rate of the reception channel (step S10a). Through the above series of operation, the Δf detection processing in the symbol differential mode is completed.

On the other hand, when a slot differential mode has been selected in the processing at step S1, the AFC controller 11 carries out a loop processing over an n slot period (step S3b to step S8b) and a loop processing over one slot period (step S4b to step S6b). One slot corresponds to ten symbols of the CPICH.

Each phase rotation quantity detecting section calculates a phase rotation quantity per one slot time (step S4b). Fig. 6 explains a method of calculating a phase rotation quantity per one slot time. A complex conjugate is obtained for one correlation value of a slot adjacent in time, and this complex conjugate is complex multiplied to the correlation value of the other slot. For example, when a symbol in the slot is composed of first to tenth symbols, a complex multiplication is carried out between a complex conjugate of the result of addition of correlation values of the second symbol, the third symbol, the sixth symbol, and the seventh symbol in the current slot, and a complex conjugate of the result of addition of correlation values of the fourth symbol, the fifth symbol, the eighth symbol, and the ninth symbol in the last slot. Similarly, a complex multiplication is carried out between a complex conjugate of the result of addition of correlation values of the fourth symbol, the fifth symbol, the eighth symbol, and the ninth symbol in the current slot, and a complex conjugate of the result of addition of correlation values of the second symbol, the third symbol, the sixth symbol, and the seventh symbol in the last slot. Then, the results of the complex multiplication are added together. This processing is carried out in a correlator unit. When a phase rotation quantity per one slot time according to a frequency deviation Δf is in a range not exceeding ±180°, it is possible to obtain a normal phase rotation quantity.

During the operation in the STTD mode, even when the phase of the modulation pattern of the CPICH transmitted from one transmission antenna is inverted by 180° at every two symbols, it is possible to obtain a phase rotation quantity per one slot time, in a similar manner to that in the non-STTD mode operation (refer to Fig. 6).

The maximum rate combiner 23 carries out a maximum rate combining to the phase rotation quantity per one slot time obtained in each correlator in the processing at step S4b (step S5b). This is set as a phase rotation quantity per one slot time in the slot.

The reliability calculating section 24 calculates reliability of the phase rotation quantity detected in the reception slot. Here, a square of a correlation value of each reception symbol in the slot is calculated, and thereafter, all results of the calculation are added (step S6b).

The n-slot averaging section 26 averages the phase rotation quantity per one slot time obtained for each slot over n slot time, in order to obtain a stable phase rotation quantity from a phase rotation quantity that instantaneously varies due to a fading variation or the like (step S8b). The effective slot deciding section 25 carries out a threshold-value decision of the squared slot integration value of a reception signal calculated at step S6b, and in the n-slot averaging, the averaging is carried out using only phase rotation quantities of slots that exceed the threshold value. In other words, by making the reception data of the slots having low correlation values non-effective, a phase rotation quantity having higher precision is obtained. In this case, the number of phase rotation quantities that are used for the averaging is counted as the reliability of the result of averaging n slots.

After completing the above loop processing, the Δf calculating section 27 calculates a frequency deviation Δf based on the obtained phase rotation quantity per one slot time and a transmission rate of the reception channel (step S10b). Through the above series of operation, the Δf detection processing in the slot differential mode is completed.

The VCO control voltage calculator 12 calculates a VCO control voltage at which Δf = 0, based on the frequency deviation Δf obtained in the processing at step S10a or step S10b (step S11). Then, VCO control is carried out using this VCO control voltage (step S12). However, as the result of carrying out a threshold-value decision of the reliability calculated at step S6a or step S6b, when the reliability is not at or above a certain level, the VCO control voltage calculator 12 regards that the reliability of the Δf detection value is low, and does not carry out VCO control. In the present embodiment, AFC is carried out based on the frequency deviation Δf obtained for every n slots as described.

The AFC controller 11 finishes the AFC operation when the reception has ended, and, when the reception is continued, the AFC operation at step S1 to step S12 is executed repeatedly again (step S13).

As explained above, in the present embodiment, based on the reliability decision, only the reception signal of a slot having high correlation of a reception symbol is selected to detect Δf. Therefore, it is possible to obtain a more stable Δf detection value with high tolerance against fading variation or the like.

Further, in the present embodiment, subsequent Δf detection is carried out by changing over between a symbol differential mode of a wide Δf detectable range and a slot differential mode of higher Δf detection precision, according to a frequency deviation Δf calculated in advance and an operation mode. Therefore, even a receiving device mounted with a VCO of low absolute precision can finally realize a high-precision lead-in of AFC. Further, when a Δf detection value has continuously exceeded a threshold value over i times or j times at the time of selecting a symbol differential mode or a slot differential mode, a forward alignment processing for changing over the operation mode is carried out. Based on this, it becomes possible to suppress the occurrence of an erroneous transition of a mode due to an erroneous detection of Δf.

### Second Embodiment

In the above-explained first embodiment, while a changeover of an AFC operation mode is carried out based on a threshold-value decision of a Δf detection value, there is a possibility that the AFC operation mode is changed over erroneously due to en erroneous detection of Δf affected by fading variation or the like. Therefore, in the second embodiment explained below, as a countermeasure against the occurrence of an erroneous transition of the AFC operation mode, a decision processing to return to a normal mode is added. The structure of the second embodiment is similar to that of the first embodiment, and therefore, identical symbols are attached and explanation thereof will be omitted.

The operation of an automatic frequency control device according to the second embodiment will be explained. Fig. 7 explains about a transition of an AFC operation mode based on a threshold-value decision. In the second embodiment, like in the first embodiment, when the AFC operation is started that has a possibility that an absolute value of a frequency deviation Δf is larger than a predetermined threshold value prescribed in advance, a symbol differential mode is selected. Thereafter, the symbol differential mode is executed continuously, and when an absolute value of a Δf detection value up to the last time has been at or lower than a threshold value over i times, for example, the mode is shifted to a slot differential mode. The slot differential mode is executed continuously, and when an absolute value of a Δf detection value up to the last time has continuously exceeded a threshold value over j times, for example, the mode is shifted to a symbol differential mode again.

In the second embodiment, during the execution of a slot differential mode, the mode is periodically shifted to a symbol differential Verify mode at a rate of once per k times of Δf detection, and the matching of a Δf detection value is confirmed using a Δf detection value, in a similar manner to that of the symbol differential mode. Specifically, during the symbol differential Verify mode, when an absolute value of a Δf detection value is at or lower than a threshold value, it is decided that the current state is not an erroneous transition and AFC is being carried out in the normal operation mode, and the mode returns to the slot differential mode again. On the other hand, during the symbol differential Verify mode, when an absolute value of a Δf detection value has continuously exceeded a threshold value over m times, it is decided that AFC lead-in to an erroneous frequency has been carried out due to an erroneous transition of the operation mode, and the mode is shifted to a symbol differential mode having a wider Δf detectable range.

As explained above, in the second embodiment, even if the mode is shifted to a slot differential mode by error due to an erroneous threshold-value decision, the mode can be shifted to a symbol differential mode again through the Verify decision. As a result, a situation that the mode cannot be returned with AFC lead-in kept in a wrong frequency does not arise, and it is thus possible to carry out an AFC lead-in to a normal frequency.

### Third Embodiment

In the above-explained first or second embodiment, the Δf detection is carried out using only a CPICH. However, there is a possibility that a frequency deviation Δf is erroneously detected due to the interference of a multichannel other than the CPICH. Therefore, in the third embodiment explained below, after carrying out the AFC lead-in in the first embodiment or the second embodiment, a success/failure decision of the AFC lead-in based on right/wrong decision of reception data is carried out. When the AFC lead-in has been a failure, a VCO control is carried out without depending on a Δf detection value, and AFC lead-in is carried out again.

Fig. 8 shows a structure of an automatic frequency control device according to the third embodiment of the present invention. Structures similar to those in the first embodiment are attached with identical symbols, and explanation thereof will be omitted. In Fig. 8, reference numeral 12a denotes a VCO control voltage calculator, 14 denotes a reception right/wrong deciding section, and 21a denotes an AFC mode controller.

Like in the first embodiment, for example, when a data demodulation by the data demodulator 10 is started after completing an AFC lead-in, the reception right/wrong deciding section 14 carries out a CRC check of reception data output by the data demodulator 10, and decides whether a normal reception is being carried out. In other words, when the result of the CRC check indicates that normal reception is carried out, it is decided that a normal AFC lead-in has been completed, and thereafter, a usual AFC control and a data demodulation are continued. On the other hand, when the result of the CRC check indicates that normal reception is not carried out, it is decided that an AFC lead-in has been a failure, and the reception right/wrong deciding section 14 instructs the AFC mode controller 21a to carry out an AFC lead-in again in a symbol differential mode.

Immediately before instructing the AFC re-lead-in instruction, the reception right/wrong deciding section 14 carries out an addition/subtraction of a VCO control voltage output from the VCO control voltage calculator 12a, without depending on a Δf detection value, and changes over a reception local frequency at the time of starting the AFC lead-in.

Fig. 9 is a flowchart of an AFC control operation according to the third embodiment. Only the operation that is different from that of the first embodiment will be explained here. After carrying out the VCO control in the processing at step S12, the reception right/wrong deciding section 14 carries out a CRC check (step S14). When the CRC check indicates that normal reception is not carried out, the VCO control voltage is controlled without depending on a Δf detection value (step S15), and thereafter, the AFC lead-in is carried out again in the symbol differential mode.

As explained above, in the third embodiment, even if an AFC lead-in to a wrong frequency has been carried out due to the influence of interference of a multichannel other than the CPICH, the AFC lead-in is carried out again. Therefore, it is possible to prevent such a situation that the AFC is kept locked to a wrong frequency.

Further, before carrying out the re-lead-in of the AFC, the VCO control voltage is added/subtracted without depending on a Δf detection value, and the reception local frequency at the time of starting the AFC lead-in is changed over in advance. Therefore, it is possible to avoid a state that the AFC lead-in to the same frequency is carried out again by error. Further, for the same reason, even if the reception local frequency has been deviated to or in excess of a Δf detectable range in the symbol differential mode, it is possible to finally complete the AFC lead-in.

As explained above, according to the present invention, based the reliability decision, a frequency deviation is detected by using the reception signal of a slot having high correlation of a reception symbol. Therefore, there is an effect that it is possible to obtain a more stable Δf detection value with high tolerance against fading variation or the like.

Moreover, subsequent frequency deviation detection processing is carried out by changing over between a first operation mode (a symbol differential mode) of a wide frequency deviation detectable range and a second operation mode (a slot differential mode) of higher frequency deviation detection precision, according to a frequency deviation detected in advance and an operation mode. Therefore, there is an effect that even a receiving device mounted with a VCO of low absolute precision can finally realize a high-precision lead-in of AFC.

Furthermore, when a frequency deviation detection value has continuously exceeded a threshold value over a predetermined number of times at the time of selecting a first operation mode and a second operation mode, a forward alignment processing for changing over the operation mode is carried out. Therefore, there is an effect that it becomes possible to suppress the occurrence of an erroneous transition of a mode due to an erroneous detection of a frequency deviation.

Moreover, even when a mode has been shifted to a second operation mode by error, the mode can be shifted to a first operation mode again through a third operation mode. Therefore, there is an effect that there is no such a situation that the mode cannot be returned with AFC lead-in kept in a wrong frequency, and it is finally possible to carry out an AFC lead-in to a normal frequency.

Furthermore, even when an AFC lead-in to a wrong frequency has been carried out due to the influence of interference of a multichannel other than the CPICH, the AFC lead-in can be carried out again. Therefore, there is an effect that it is possible to prevent such a situation that the AFC is kept locked to a wrong frequency, particularly when there has been interference of a channel like the PCCPCH in which codes having relatively similar characteristics are used for spreading like in the CPICH. Further, before carrying out the re-lead-in of AFC, the VCO control is carried out without depending on a frequency deviation detection value, and the reception local frequency at the time of starting the AFC lead-in is changed over in advance. Therefore, there is an effect that it is possible to avoid a state that the AFC lead-in to the same frequency is carried out again by error. Further, for the same reason, there is an effect that even when the reception local frequency has been deviated to or in excess of a frequency deviation detectable range in a first operation mode, it is possible to finally complete the AFC lead-in.

Moreover, based the reliability decision, a frequency deviation is detected by using only the reception signal of a slot having high correlation of a reception symbol. Therefore, there is an effect that it is possible to obtain a more stable Δf detection value with high tolerance against fading variation or the like.

Furthermore, subsequent frequency deviation detection processing is carried out by changing over between a first operation mode (a symbol differential mode) of a wide frequency deviation detectable range and a second operation mode (a slot differential mode) of higher frequency deviation detection precision, according to a frequency deviation calculated in advance and an operation mode. Therefore, there is an effect that even a receiving device mounted with a VCO of low absolute precision can finally realize a high-precision lead-in of AFC.

Moreover, when a frequency deviation detection value has continuously exceeded a threshold value over a predetermined number of times at the time of selecting a first operation mode and a second operation mode, a forward alignment processing for changing over the operation mode is carried out. Therefore, there is an effect that it becomes possible to suppress the occurrence of an erroneous transition of a mode due to an erroneous detection of a frequency deviation.

Furthermore, even when a mode has been shifted to a second operation mode by error, the mode can be shifted to a first operation mode again through a third operation mode. Therefore, there is an effect that there is no such a situation that the mode cannot be returned with AFC lead-in kept in a wrong frequency, and it is finally possible to carry out an AFC lead-in to a normal frequency.

Moreover, even when an AFC lead-in to a wrong frequency has been carried out due to the influence of interference of a multichannel other than the CPICH, the AFC lead-in can be carried out again. Therefore, there is an effect that it is possible to prevent such a situation that the AFC is kept locked to a wrong frequency, particularly when there has been interference of a channel like the PCCPCH in which codes having relatively similar characteristics are used for spreading like in the CPICH. Further, before carrying out the re-lead-in of AFC, the VCO control is carried out without depending on a frequency deviation detection value, and the reception local frequency at the time of starting the AFC lead-in is changed over in advance. Therefore, there is an effect that it is possible to avoid a state that the AFC lead-in to the same frequency is carried out again by error. Further, for the same reason, there is an effect that even when the reception local frequency has been deviated to or in excess of a frequency deviation detectable range in a first operation mode, it is possible to finally complete the AFC lead-in.

### INDUSTRIAL APPLICABILITY

As explained above, the automatic frequency control device and the automatic frequency control method relating to the present invention are suitable for an automobile telephone, a portable telephone and the like that use the W-CDMA communication technique.

## Claims

1. An automatic frequency control (hereinafter "AFC") device that obtains a frequency deviation based on outputs of a plurality of correlators, comprising:
an operation mode control unit that changes over a unit time (hereinafter "an operation mode") to calculate a phase rotation quantity according to a frequency deviation calculated in advance;
a phase rotation quantity detecting unit that detects a phase rotation quantity per unit time, by using symbol correlation values of channels in which known data is transmitted between a transmitter and a receiver, obtained as the outputs of the correlators according to a specified operation mode;
a data deciding unit that decides effectiveness or non-effectiveness of reception data in a receiving slot by using the symbol correlation values;
a slot averaging unit that averages the phase rotation quantity per unit time corresponding to the receiving slot that has been decided as effective, during a predetermined slot time;
a frequency deviation/rellability calculating unit that calculates a frequency deviation based on the phase rotation quantity after averaging, and calculates reliability of the frequency deviation based on the effective number; and
a VCO control unit that decides reliability of the calculated frequency deviation, and carries out a voltage controlled oscillation (hereinafter "VCO") control when the reliability exceeds a certain level.

2. The automatic frequency control device according to claim 1, wherein, as the operation mode,
the operation mode control unit selects between a first operation mode for detecting a frequency deviation based on a phase rotation quantity per one symbol time and a second operation mode for detecting a frequency deviation based on a phase rotation quantity per one slot time.

3. The automatic frequency control device according to claim 2, further comprising:
a reception right/wrong deciding unit that decides right or wrong of reception data after a demodulation, and decides that an AFC lead-in has been a failure and instructs the VCO control unit to carry out VCO control without depending on the detected frequency deviation, when the result of the decision is that a predetermined standard is not satisfied, and thereafter instructs the operation mode control unit to carry out the AFC lead-in again in the first operation mode.

4. The automatic frequency control device according to claim 2, wherein the operation mode control unit
switches to the second operation mode in which it is possible to detect a frequency deviation in higher precision, when an absolute value of the detected frequency deviation has been continuously equal to or lower than a threshold value over a first predetermined number of times prescribed in advance during a continuous operation in the first operation mode, and
switches to the first operation mode in which a detectable range of a frequency deviation is wide, when an absolute value of the detected frequency deviation has continuously exceeded a threshold value over a second predetermined number of times prescribed in advance during a continuous operation in the second operation mode.

5. The automatic frequency control device according to claim 4, further comprising:
a reception right/wrong deciding unit that decides right or wrong of reception data after a demodulation, and decides that an AFC lead-in has been a failure and instructs the VCO control unit to carry out VCO control without depending on the detected frequency deviation, when the result of the decision is that a predetermined standard is not satisfied, and thereafter instructs the operation mode control unit to carry out the AFC lead-in again in the first operation mode.

6. The automatic frequency control device according to claim 2, wherein the operation mode control unit
switches to the second operation mode in which it is possible to detect a frequency deviation in higher precision, when an absolute value of the detected frequency deviation has been continuously equal to or lower than a threshold value over a first predetermined number of times prescribed in advance during a continuous operation in the first operation mode,
switches to the first operation mode in which a detectable range of a frequency deviation is wide, when an absolute value of the detected frequency deviation has continuously exceeded a threshold value over a second predetermined number of times prescribed in advance during a continuous operation in the second operation mode, and
periodically switches to a third operation mode at a rate of once per a specified number of times of detecting a frequency deviation during a continuous operation in the second operation mode, returns to the second operation mode when an absolute value of the detected frequency deviation is equal to or lower than a threshold value, and shifts to the first operation mode when an absolute value of the detected frequency deviation has continuously exceeded a threshold value over a third predetermined number of times.

7. The automatic frequency control device according to claim 6, further comprising:
a reception right/wrong deciding unit that decides right or wrong of reception data after a demodulation, and decides that an AFC lead-in has been a failure and instructs the VCO control unit to carry out VCO control without depending on the detected frequency deviation, when the result of the decision is that a predetermined standard is not satisfied, and thereafter instructs the operation mode control unit to carry out the AFC lead-in again in the first operation mode.

8. An automatic frequency control method comprising:
an operation mode control step of changing over a unit time (hereinafter "an operation mode") to calculate a phase rotation quantity according to a frequency deviation calculated in advance;
a phase rotation quantity detecting step of detecting a phase rotation quantity per unit time, by using symbol correlation values of channels in which known data is transmitted between a transmitter and a receiver, obtained as outputs of a plurality of correlators according to a specified operation mode;
a data deciding step of deciding effectiveness or non-effectiveness of reception data in a receiving slot by using the symbol correlation values;
a slot averaging step of averaging the phase rotation quantity per unit time corresponding to the receiving slot that has been decided as effective, during a predetermined slot time;
a frequency deviation/reliability calculating step of calculating a frequency deviation based on the phase rotation quantity after averaging, and calculating reliability of the frequency deviation based on the effective number; and
a VCO control step of deciding reliability of the calculated frequency deviation, and carrying out a voltage controlled oscillation (hereinafter "VCO") control when the reliability exceeds a certain level.

9. The automatic frequency control method according to claim 8, wherein, at the operation mode control step,
it is made possible to select a first operation mode for detecting a frequency deviation based on a phase rotation quantity per one symbol time, and a second operation mode for detecting a frequency deviation based on a phase rotation quantity per one slot time.

10. The automatic frequency control method according to claim 9, further comprising:
a reception right/wrong deciding step of deciding right or wrong of reception data after a demodulation, and deciding that an AFC lead-in has been a failure and instructing to carry out a VCO control without depending on the detected frequency deviation, when the result of the decision is that a predetermined standard is not satisfied, and thereafter instructing to carry out an AFC lead-in again in the first operation mode.

11. The automatic frequency control method according to claim 9, wherein, at the operation mode control step, the operation mode is shifted to the second operation mode in which it is possible to detect a frequency deviation in higher precision, when an absolute value of the detected frequency deviation has been continuously equal to or lower than a threshold value over a first predetermined number of times prescribed in advance during a continuous operation in the first operation mode, and
the operation mode is shifted to the first operation mode in which a detectable range of a frequency deviation is wide, when an absolute value of the detected frequency deviation has continuously exceeded a threshold value over a second predetermined number of times prescribed in advance during a continuous operation in the second operation mode.

12. The automatic frequency control method according to claim 11, further comprising:
a reception right/wrong deciding step of deciding right or wrong of reception data after a demodulation, and deciding that an AFC lead-in has been a failure and instructing to carry out a VCO control without depending on the detected frequency deviation, when the result of the decision is that a predetermined standard is not satisfied, and thereafter instructing to carry out an AFC lead-in again in the first operation mode.

13. The automatic frequency control method according to claim 9, wherein, at the operation mode control step,
the operation mode is shifted to the second operation mode in which it is possible to detect a frequency deviation in higher precision, when an absolute value of the detected frequency deviation has been continuously equal to or lower than a threshold value over a first predetermined number of times prescribed in advance during a continuous operation in the first operation mode,
the operation mode is shifted to the first operation mode in which a detectable range of a frequency deviation is wide, when an absolute value of the detected frequency deviation has continuously exceeded a threshold value over a second predetermined number of times prescribed in advance during a continuous operation in the second operation mode, and
the operation mode is periodically shifted to a third operation mode at a rate of once per a specified number of times of detecting a frequency deviation during a continuous operation in the second operation mode, the operation mode is returned to the second operation mode when an absolute value of the detected frequency deviation is equal to or lower than a threshold value, and the operation mode is shifted to the first operation mode when an absolute value of the detected frequency deviation has continuously exceeded a threshold value over a third predetermined number of times.

14. The automatic frequency control method according to claim 13 further comprising:
a reception right/wrong deciding step of deciding right or wrong of reception data after a demodulation, and deciding that an AFC lead-in has been a failure and instructing a VCO control without depending on the detected frequency deviation, when the result of the decision is that a predetermined standard is not satisfied, and thereafter instructing to carry out the AFC lead-in again in the first operation mode.
